# EUROPÄISCHE PATENTANMELDUNG

(11) **EP 0 785 474 A1**
(43) Veröffentlichungstag der Anmeldung: **23.07.1997**
(21) Anmeldenummer: 96100577.4
(22) Anmeldetag: 16.01.1996
(51) Int. Cl.: G03F 7/24, G03F 7/095

(54) **Verfahren und Vorrichtung zur Herstellung einer Flexodruckschablone**

(71) Anmelder: Schablonentechnik Kufstein Aktiengesellschaft, 6330 Kufstein (AT)
(72) Erfinder: Die Erfindernennung liegt noch nicht vor
(74) Vertreter: TER MEER STEINMEISTER & PARTNER GbR

(57) **Zusammenfassung**

Bei der Herstellung einer Flexodruckschablone erfolgt zunächst die Bereitstellung eines Trägers (1), wonach eine vergleichsweise dicke Fotoelastomerschicht (2) auf die Oberfläche des Trägers (1) aufgebracht wird, um anschließend eine vergleichsweise dünne lichtempfindliche Schicht (3) auf die Oberfläche der Fotoelastomerschicht (2) aufzutragen. Sodann erfolgt ein punktweises Belichten der dünnen lichtempfindlichen Schicht (3) mittels wenigstens eines feinen Lichtstrahlenbündels sowie anschließend das Entwickeln der dünnen lichtempfindlichen Schicht (3). Danach wird die Fotoelastomerschicht (2) unter Verwendung der verbliebenen Bereiche der dünnen lichtempfindlichen Schicht (3) als Maske großflächig belichtet und sodann entwickelt.

## Beschreibung

Die Erfindung bezieht sich auf ein Verfahren zur Herstellung einer Flexodruckschablone.

Aus der AT-PS 326 703 ist bereits ein Verfahren zur Herstellung von Druckformen mit Hilfe zweier auf eine Matrize oder einen Druckformträger aufgebrachter, lichtempfindlicher Schichten bekannt, aufwelche das Muster aufgelichtet, entwickelt und auf chemischem bzw. galvanischem Wege zur Druckform gestaltet wird. Dabei erfolgt die Belichtung der oberen hochlichtempfindlichen Schicht durch zeitlich aufeinanderfolgende Einzelprojektion musterbedingter Rasterpunkte, während die unter der oberen lichtempfindlichen Schicht angeordnete, weniger lichtempfindliche und gegen galvanische Bäder oder Ätzchemikalien beständige zweite Schicht zeitlich nach der punktweisen Einzelprojektion und der Entwicklung der musterbedingten Rasterpunkte auf der obersten Schicht großflächig belichtet wird.

Mit Hilfe des bekannten Verfahrens können Druckformen für Hochdruck oder Tiefdruck hergestellt werden, wobei nach dem Belichten und dem anschließenden Entwickeln ein dem Druckmuster entsprechendes Oberflächenrelief in der Druckform durch Ätzen erzeugt wird.

Bei einem weiteren zum Stand der Technik gehörenden Verfahren zur Herstellung einer Hochdruckform, bei welcher die druckenden Stellen reliefartig erhaben ausgebildet sind, wird auf ein dünnes Metallrohr ein plattenförmiges Fotoelastomer aufgebracht. Dieses Fotoelastomer ist noch nicht vollständig vernetzt und daher noch schmelzbar und auch chemisch auflösbar. Zwischen Metallrohr und Fotoelastomer wird ein Haftvermittler gestrichen. Das Fotoelastomer wird anschließend mit einer hitzebeständigen Folie umwickelt und schließlich durch Erhitzen auf das Metallrohr aufgeschmolzen. Nach diesem Backvorgang wird der erzeugte Gummi-Metallzylinder auf eine Genauigkeit von 5 µm rundgeschliffen, um insbesondere die beim Aufschmelzvorgang entstehende Stoßkante zu beseitigen. In weiterer Folge wird bei diesem Verfahren ein das Druckmuster tragender Ganzfilm um die Rundform gewickelt und das Polymer durch die nicht geschwärzten Stellen dieses Films mit UV-Strahlung (360 bis 380 nm) großflächig belichtet und dadurch zur vollständigen Vernetzung veranlaßt. Anschließend werden die nicht vollständig vernetzten Stellen durch einen Entwickler oder Stripper aus der Fotoelastomerschicht herausgelöst.

Bei einem noch anderen zum Stand der Technik gehörenden Verfahren erfolgt die Belichtung während der großflächigen UV-Strahlung durch einen ein sehr kleines Segment der Flexodruckform umschließenden Film. Hierbei wälzt sich der Film an der Flexodruckform ab. An der Abwälzstelle ist eine schmale Belichtungszone vorgesehen. Durch dieses Abwälzverfahren kann das Muster praktisch nahtfrei auf die Flexodruckform übertragen werden, vorausgesetzt, daß die kinematische Genauigkeit der Abwälzung und auch die Genauigkeit der Druckform ausreichen.

Der Erfindung liegt die Aufgabe zugrunde, ein weiteres Verfahren anzugeben, mit dem sich Flexodruckschablonen leichter herstellen lassen.

Darüber hinaus ist es Aufgabe der Erfindung, eine geeignete Vorrichtung zur Durchführung des Verfahrens zu schaffen.

Ein Verfahren nach der Erfindung zur Herstellung einer Flexodruckschablone zeichnet sich durch folgende Schritte aus:
- Bereitstellung eines Trägers;
- Aufbringen einer vergleichsweise dicken Fotoelastomerschicht auf die Oberfläche des Trägers;
- Aufbringen einer vergleichsweise dünnen lichtempfindlichen Schicht auf die Oberfläche der Fotoelastomerschicht;
- punktweises Belichten der dünnen lichtempfindlichen Schicht mittels wenigstens eines feinen Lichtstrahlenbündels sowie anschließendes Entwickeln der dünnen lichtempfindlichen Schicht; und
- großflächiges Belichten der Fotoelastomerschicht unter Verwendung der verbliebenen Bereiche der dünnen lichtempfindlichen Schicht als Maske sowie anschließendes Entwickeln der Fotoelastomerschicht.

Nach einer vorteilhaften Ausgestaltung der Erfindung wird als feines Lichtstrahlenbündel ein Laserstrahlbündel verwendet, das über eine Fokussierungsoptik auf die dünne lichtempfindliche Schicht bzw. deren Oberfläche fokussiert wird. Dabei kann der das Laserstrahlenbündel erzeugende Laser relativ zum Träger bewegt werden. Das Laserstrahlenbündel kann aber auch über einen Umlenkspiegel entsprechend abgelenkt werden, der relativ zum Träger verfahrbar ist.

Das großflächige Belichten erfolgt nach einer anderen Ausgestaltung der Erfindung mit Strahlung, deren Ausbreitungsrichtung im wesentlichen senkrecht zur Oberfläche der Fotoelastomerschicht verläuft. Hierdurch wird erreicht, daß die Fotoelastomerschicht im wesentlichen nur zwischen den durch die Maske gebildeten Musterstrukturen vernetzt wird und damit aushärtet und nicht noch in größeren Bereichen unterhalb der Musterstrukturen, so daß sich im Hinblick auf die Flexodruckschablone erhabene Bereiche mit genaueren Abmessungen ergeben.

Die Fotoelastomerschicht selbst kann z. B. eine Dicke von 2 bis 5 mm aufweisen und somit hinreichend elastische Eigenschaften für den späteren Einsatz besitzen.

Nach einer sehr vorteilhaften Ausgestaltung der Erfindung wird die dünne lichtempfindliche Schicht durch Aufbringen eines Positiv- oder Negativ-Fotolacks gebildet oder durch Aufbringen einer Silberhalogenid-Gelatinelösung oder eines Silberhalogenid-Polyvinylalkohols. Es hat sich wider Erwarten herausgestellt, daß sich diese Substanzen auch auf eine Fotoelastomerschicht mit sehr hoher Gleichmäßigkeit auftragen lassen, so daß nicht mehr auf Filme zur Belichtung der Fotoelastomerschicht zurückgegriffen werden muß.

Als Träger können nicht nur flache bzw. ebene sondern auch zylindrische und vorzugsweise hohlzylindrische Träger zum Einsatz kommen. Sie bestehen vorzugsweise aus Metall, Kunststoff oder z. B. auch aus glasfaserverstärktem Kunststoff bzw. aus CFK-Materialien, wenn es auf hohe Festigkeit bzw. Steifigkeit ankommt, etwa im Falle hohlzylindrischer Träger.

Insbesondere im Fall zylindrischer bzw. hohlzylindrischer Träger hat sich zum Aufbringen der dünnen lichtempfindlichen Schicht der Einsatz von Tauchverfahren oder Tauchringrakelverfahren, ggf. in Kombination mit Luftrakeln, bewährt. Durch den Einsatz dieser Verfahren läßt sich die dünne lichtempfindliche Schicht noch gleichmäßiger auf die Fotoelastomerschicht aufbringen. Insbesondere läßt sich Ihre Dicke dadurch sehr konstant halten. Die dünne lichtempfindliche Schicht kann aber auch durch Aufsprühen gebildet werden, etwa indem eine Sprühdüse bei sich drehendem Zylinder entlang der Zylinderachse bewegt wird und dabei das Schichtmaterial auf die Fotoelastomerschicht aufsprüht.

Nach einervorteilhaften Weiterbildung der Erfindung wird bei einem hohlzylindrischen Träger während der punktweisen Belichtung der dünnen lichtempfindlichen Schicht ein Überdruck im Innern des Hohlzylinders erzeugt, was zu einer völligen Ausrundung des Hohlzylinders führt und damit zu einem genaueren Muster auf der Oberfläche der Fotoelastomerschicht.

Die großflächige Belichtung der Fotoelastomerschicht kann so erfolgen, daß diese bis nahe oder bis ganz zum Boden vernetzt wird. Dadurch läßt sich verhindern, daß beim anschließenden Entwicklungsschritt u. U. ausgehärtete Bereiche aus der Fotoelastomerschicht versehentlich herausgelöst werden, insbesondere dann, wenn beim Entwickeln der Fotoelastomerschicht das Herauslösen von unvernetzten Stellen aus dem Polymerverband durch einen Bürstvorgang unterstützt wird.

Die entwickelte Fotoelastomerschicht kann darüber hinaus nach einer weiteren Ausgestaltung der Erfindung durch großfläche Belichtung nachvernetzt werden, um einen stabileren Polymerverband zu erhalten, der auch resistent ist gegen das spätere Auftragen von Druckfarben.

Eine Vorrichtung zur Durchführung des erfindungsgemäßen Verfahrens enthält eine an sich bekannte Bearbeitungsstation, die wenigstens eine Lagereinrichtung zur stirnseitigen Lagerung eines Zylinders sowie eine Antriebseinrichtung zur Drehung des Zylinders um seine Zylinderachse aufweist, wobei an der Bearbeitungsstation ein Lichtbalken angeordnet ist, der sich bei eingespanntem Zylinder über dessen gesamte Länge in Zylinderlängsrichtung erstreckt und durch einen Spalt hindurch Licht In Richtung zum Zylinder abstrahlt. Dabei kann der Spalt durch einen in Längsrichtung des Lichtbalkens verlaufenden schmalen Trichter gebildet sein, der auf die Rotationsachse des Zylinders ausgerichtet ist, um dafür zu sorgen, daß in noch stärkerem Maße das großflächige Belichten der Fotoelastomerschicht mit Strahlung so erfolgt, daß deren Ausbreitungsrichtung im wesentlichen senkrecht zur Oberfläche der Fotoelastomerschicht verläuft.

Die Bearbeitungsstation kommt somit in erster Linie zum Einsatz, wenn es um die großflächige Belichtung der Fotoelastomerschicht geht, die sich auf der Oberfläche des Zylinders befindet. Möglich ist aber auch, an der Bearbeitungsstation einen parallel zur Zylinderachse bewegbaren Bearbeitungstisch vorzusehen sowie eine Steuerung zum Transport des Bearbeitungstisches in Zylinderlängsrichtung, um über diesen Bearbeitungstisch einen Laserstrahl in Richtung auf die Zylinderoberfläche zu lenken, so daß sich die Vorrichtung dann auch zur Belichtung der dünnen lichtempfindlichen Schicht mittels eines Lasers eignen würde, der zum Beispiel am Bearbeitungstisch montiert ist und von diesem mitbewegt wird. Bei stationärem Laser könnte entsprechend ein Umlenkspiegel am Bearbeitungstisch zur Umlenkung des Laserstrahls auf den Zylinder vorgesehen sein.

Die Erfindung wird nachfolgend unter Bezugnahme auf die Zeichnung näher beschrieben. Es zeigen:
**Figur 1** einen Querschnitt durch einen hohlzylindrischen Träger mit äußerer Fotoelastomerschicht und einer darauf liegenden dünnen lichtempfindlichen Schicht;
**Figur 2** einen vergrößerten Ausschnitt aus der Struktur nach Figur 1;
**Figur 3** eine Vorrichtung zur Belichtung der dünnen lichtempfindlichen Schicht;
**Figur 4** eine weitere Vorrichtung zur Belichtung der Fotoelastomerschicht nach Belichtung und Entwicklung der dünnen lichtempfindlichen Schicht; und
**Figur 5** eine Vorrichtung zum Entwickeln der Fotoelastomerschicht.

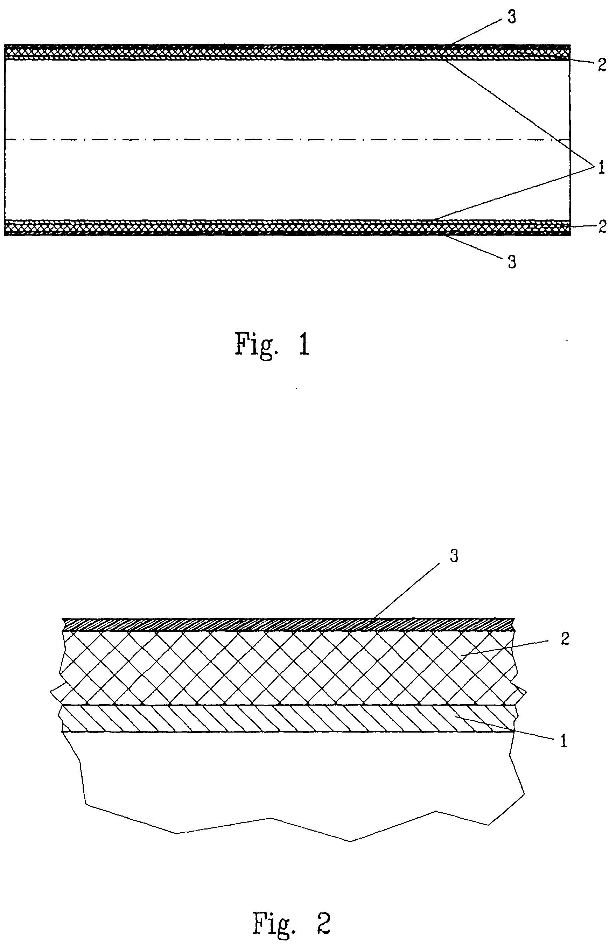

In der Figur 1 bezeichnet das Bezugszeichen 1 ein dünnes Metallrohr, also einen Hohlzylinder. Dieses Metallrohr 1 wird ein bis zwei Zehntel Millimeter dick zum Beispiel durch galvanische Abscheidung hergestellt. Auf dieses Metallrohr 1 wird ein noch nicht vollständig vernetztes, plattenförmiges Fotoelastomer 2 aufgebracht. Dessen Schichtstärke beträgt etwa 3 mm. Über das Fotoelastomer 2 wird eine hochlichtempfindliche, dünne Schicht 3 gelegt. Diese dünne lichtempfindliche Schicht 3 kann z. B. durch ein Tauch- oder Tauchringrakelverfahren aufgetragen werden. Die Schicht 3 besteht z. B. aus einem Positiv- oder Negativ-Resist, kann aber auch eine Silberhalogenid-Gelatinelösung (AgBr oder AgJ) sein.

Die Figur 2 zeigt einen vergrößerten Ausschnitt aus Figur 1, wobei hier die gleichen Bezugszeichen gelten.

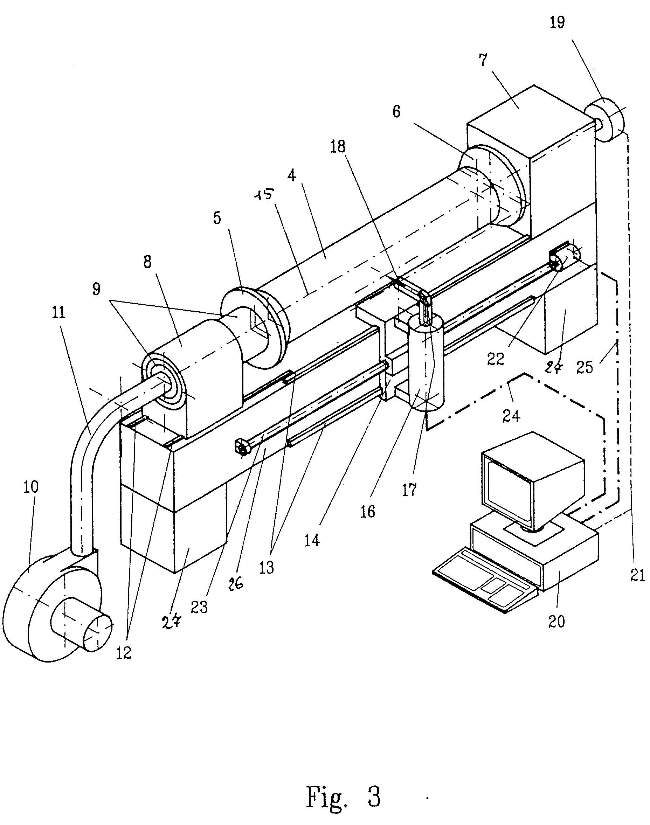

Die Figur 3 zeigt eine Vorrichtung zur Laser-Belichtung der dünnen lichtempfindlichen Schicht 3. Die aus dem Hohlzylinder 1 und den Schichten 2 und 3 bestehende fertige Druckform 4 ist hier zwischen zwei kegelstumpfförmigen Mitnehmern 5 und 6 drehbar gelagert. Der Mitnehmer 6 wird über einen Spindelstock 7 mit einem darin untergebrachten und nicht dargestellten Motor angetrieben. Der am Reitstock 8 gelagerte Mitnehmer 5 dient nur zur Führung und Abstützung der Druckform 4. Dabei greifen die Mitnehmer 5 und 6 in die offenen Stirnseiten der Druckform 4 ein. Durch eine Hohlwelle 9 im Reitstock 8 kann über ein Ringkammergebläse 10 und eine Druckluftleitung 11 Luft mit geringem Überdruck in die Druckform 4 eingeblasen werden. Zweckmäßig wird der Druck mit 0,002 bis 0,5 bar gewählt. Durch diese Maßnahme kann die Druckform kreisrund gehalten werden, wenn die Druckform 4 einen entsprechend dünnen Träger 1 enthält, z. B. ein dünnes Nickelrohr. Der Reitstock 8 ist entlang von Führungen 12 auf die jeweilige Länge der Druckform 4 einstellbar. Auf weiteren Führungen 13 fährt ein Schlitten 14 parallel zur Achse 15 der zylindrischen Druckform 4. Auf dem Schlitten 14 ist ein kleiner Laser 16 montiert. Der vom Laser 16 emittierte Strahl wird über einen Umlenkspiegel 17 und eine Laseroptik 18 auf die Oberfläche der Druckform 4 gelenkt, genauer gesagt auf die Oberfläche der dünnen lichtempfindlichen Schicht 3, und dort auf einen Durchmesser von vorzugsweise 10 bis 25 µm fokussiert. Eine ggf. verbleibende Rundlaufschwankung kann durch die Anwendung einer adaptiven Optik ausgeglichen werden, wie dies bereits bekannt ist. Ein Drehwinkelencoder 19 sendet während des Rundlaufs der Druckform 4 Impulse an einen Steuerrechner 20 über eine Signalleitung 21, während ein Schirmmotor 22 auf eine Spindel 23 wirkt und so den Schlitten 14 mit dem Laser 16 entlang der Führungen 13 verschiebt.

Der Steuerrechner 20 vergleicht die Winkellage der Druckform 4 mit einer in einem Massenspeicher des Rechners 20 abgelegten Musterinformation, ermittelt und sendet sowohl die Ein- und Ausschaltimpulse an den Laser 16 über eine Leitung 24 und sendet auch die Schrittimpulse an den Schrittmotor 22 über eine Leitung 25. Durch das Ein- bzw. Ausschalten des Lasers 16 wird die hochlichtempfindliche Schicht 3 punktförmig belichtet, und zwar mustergemäß. Diese Punkte können dann zu einer schmalen Spur zusammenwachsen, wenn der Laser über längere Zeit musterbedingt eingeschaltet bleibt. Diese Punkte haben einen Durchmesser, welcher dem Fokuspunkt entspricht. Da die Belichtungszeit für einen Einzelpunkt ≤ 1 µs ist, kann zwar die lichtempfindliche Schicht 3 belichtet werden, aber für das darunterliegende Fotopolymer 2 ist die Belichtung viel zu schwach, als daß eine nennenswerte Vernetzung oder Polymerisation stattfinden könnte. Diese wäre auch dann in keiner Weise für eine Vernetzung des Fotopolymers 2 ausreichend, wenn die hochlichtempfindliche Schicht 3 und damit deren Absorption entfallen würde.

Anschließend an diesen Laserbelichtungsvorgang erfolgt die Entwicklung der äußeren dünnen lichtempfindlichen Schicht 3 zum Beispiel durch peripheres Eintauchen der Druckform 4 in ein alkalisches Bad. Es kann alternativ die Schicht 3 auch mit alkalischer Flüssigkeit besprüht werden. Durch diesen ersten Entwicklungsprozeß werden je nach Resist-Typ die belichteten oder die unbelichteten Stellen aus der lichtempfindlichen Schicht 3 herausgelöst und die jeweils entgegengesetzt belichteten Stellen verbleiben als lichtabdeckende Maske für die nachfolgende Flächenbelichtung der Fotoelastomerschicht 2.

Gelatine- oder Polyvinylalkoholschichten, welche Silberhalogenid-Kristalle enthalten, werden auf eine ganz ähnliche Weise mit einer alkalischen Entwicklerflüssigkeit behandelt, nur enthält diese zusätzlich ein organisches Reduktionsmittel zur Reduktion der belichteten Silberhalogenide zu nicht löslichem, metallischen Silber. Diese Flüssigkeiten sind als Schwarz/Weiß-Entwickler aus der Fotografie bekannt. Anschließend erfolgt hier noch ein Fixiervorgang, d. h. ein Herauslösen der nicht zu Silber reduzierten, also der nicht belichteten Silberhalogenide.

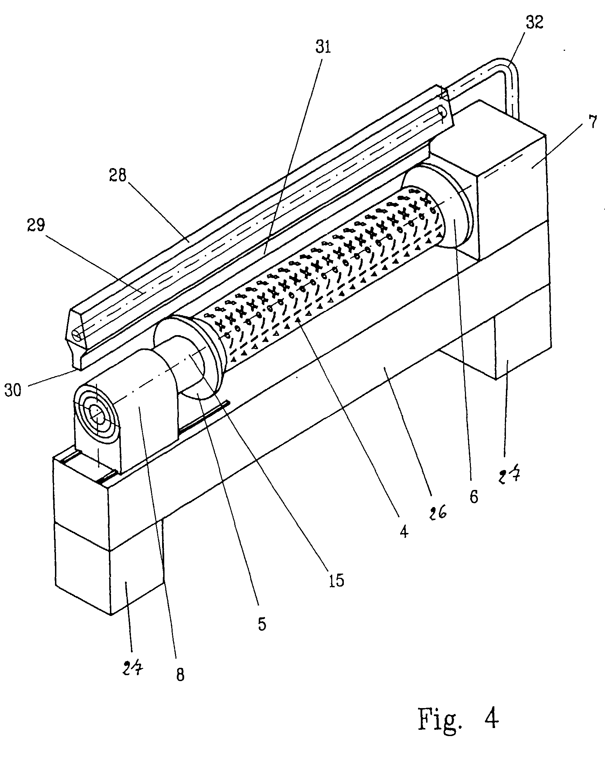

In Figur 4 wird die großflächige Belichtung der Druckform 4 gezeigt, also die großflächige Belichtung der Fotoelastomerschicht 2, welche auf ihrer Oberfläche jetzt die lichtundurchlässige Maske trägt. Die entsprechende Vorrichtung zur Belichtung der Fotoelastomerschicht 3 ist ähnlich der in Figur 3 gezeigten Vorrichtung aufgebaut. Nur ist hier der Schlitten 14 mit den, auf ihm montierten Laser 16 nicht vorhanden. Wie bei der Vorrichtung nach Figur 3 wird auch hier die Druckform 4 von zwei kegelstumpfförmigen Mitnehmern 5 und 6 drehbar aufgenommen und über den Mitnehmer 6 angetrieben. Oberhalb der Druckform 4 und parallel zu ihrer Längsachse 15 ist ein Lichtbalken 28 angeordnet, der einen Xenonbrenner 29 in seinem Innern enthält. Der Xenonbrenner 29 erstreckt sich über die gesamte Länge des Lichtbalkens 28. Das Licht verläßt den Lichtbalken 28 durch einen schmalen Schlitz 30 im unteren Bereich eines Lichttrichters 31. Dieser Lichttrichter 31 ist mit dem Lichtbalken 28 verbunden. Wegen dieses Lichtaustritts trifft das Licht in Form eines schmalen Lichtbandes auf die Oberfläche der Druckform 4 auf, wobei die Ausbreitungsrichtung des Lichtes im wesentlichen senkrecht zur Oberfläche der Fotoelastomerschicht 3 verläuft. Hier dringt es nur an den Stellen in das Fotopolymer ein, die nicht durch lichtabsorbierende Stellen der Maske abgedeckt sind. Außerdem kann es wegen der Abblendung durch den Lichttrichter 31 im wesentlichen nur senkrecht zur Oberfläche des Fotopolymers verlaufen, wie bereits erwähnt. Durch den vorgeschlagenen Xenonbrenner 29 steht eine preisgünstige UV-Quelle auch im Bereich von 360 bis 380 nm für die Vernetzung des Fotopolymers 2 zur Verfügung. Der Lichtbalken 28 ist mittels eines Rohrbogens 32 am Spindelstock 7 befestigt. Wie auch bei der Vorrichtung nach Figur 3 stehen Spindelstock 7 und Reitstock 8 auf einem Maschinenbett 26, welches sich seinerseits über Sockel 27 am Boden abstützt. Die Führungen 12 und 13 sowie die Spindel 23 sind an diesem Maschinenbett 26 montiert.

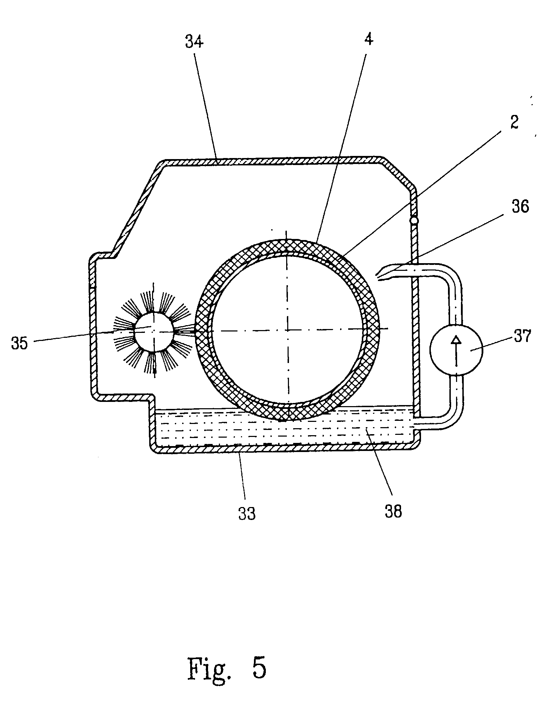

In Figur 5 wird schließlich der letzte Schritt der Herstellung der Flexodruckschablone gezeigt. Die Stellen des Fotoelastomers 2, welche nicht durch UV-Strahlung permanent vernetzt wurden, werden in einem durch einen klappbaren Deckel 34 verschließbaren Spülbecken 33 durch eine zweite Entwicklerflüssigkeit aus dem Polymerverband herausgelöst bzw. herausgewaschen. Bei diesem Entwickler handelt es sich um ein Gemisch aus Butanol [CH3(CH2)3 OH] und Perchloräthylen [C2 C14]. Eine Chemikalienpumpe 37 bringt laufend Entwicklerflüssigkeit zu den Düsen 36 und von diesen wird der Entwickler auf die Druckform 4 aufgesprüht. Zusätzlich wird der Abtragungseffekt durch eine rotierende Bürste 35 unterstützt. Durch diese kombinierte mechanisch-chemische Behandlung werden die unvernetzten Stellen langsam aus dem Polymerverband herausgelöst. Nach diesem Behandlungsschritt liegt die Druckform 4 bzw. Flexodruckschablone als ein reliefartiges, mehr oder weniger gummielastisches Gebilde vor, bei welchem die erhabenen Stellen auf einem sehr genauen Kreiszylindermantel liegen. Die nicht druckenden Teile der Flexodruckschablone liegen in den Tälern. Diese werden beim später ablaufenden Druckprozeß nicht benötigt und daher nicht eingefärbt.

## Patentansprüche

1. Verfahren zur Herstellung einer Flexodruckschablone mit folgenden Schritten:
- Bereitstellung eines Trägers (1);
- Aufbringen einer vergleichsweise dicken Fotoelastomerschicht (2) auf die Oberfläche des Trägers (1);
- Aufbringen einer vergleichsweise dünnen lichtempfindlichen Schicht (3) auf die Oberfläche der Fotoelastomerschicht (2);
- punktweises Belichten der dünnen lichtempfindlichen Schicht (3) mittels wenigstens eines feinen Lichtstrahlenbündels sowie anschließendes Entwickeln der dünnen lichtempfindlichen Schicht (3); und
- großflächiges Belichten der Fotoelastomerschicht (2) unter Verwendung der verbliebenen Bereiche der dünnen lichtempfindlichen Schicht (3) als Maske sowie anschließendes Entwickeln der Fotoelastomerschicht (2).

2. Verfahren nach Anspruch 1, **dadurch gekennzeichnet,** daß als feines Lichtstrahlenbündel ein Laserstrahlenbündel verwendet wird.

3. Verfahren nach Anspruch 1 oder 2, **dadurch gekennzeichnet,** daß das großflächige Belichten mit Strahlung erfolgt, deren Ausbreitungsrichtung im wesentlichen senkrecht zur Oberfläche der Fotoelastomerschicht (2) verläuft.

4. Verfahren nach einem der Ansprüche 1 bis 3, **dadurch gekennzeichnet,** daß die Fotoelastomerschicht (2) mit einer Dicke von etwa 2 bis 5 mm hergestellt wird.

5. Verfahren nach einem der Ansprüche 1 bis 4, **dadurch gekennzeichnet,** daß die dünne lichtempfindliche Schicht (3) durch Aufbringen eines Positiv- oder Negativ-Fotolacks gebildet wird.

6. Verfahren nach einem der Ansprüche 1 bis 4, **dadurch gekennzeichnet,** daß die dünne lichtempfindliche Schicht (3) durch Aufbringen einer Silberhalogenid-Gelatinelösung oder eines -Polyvinylalkohols gebildet wird.

7. Verfahren nach Anspruch 6, **dadurch gekennzeichnet,** daß die dünne lichtempfindliche Schicht (3) nach dem Entwickeln fixiert wird.

8. Verfahren nach einem der Ansprüche 1 bis 7, **dadurch gekennzeichnet,** daß als Träger (1) ein zylindrischer, vorzugsweise hohlzylindrischer Träger verwendet wird.

9. Verfahren nach Anspruch 8, **dadurch gekennzeichnet,** daß die auf dem Zylinder bzw. Hohlzylinder liegende Fotoelastomerschicht (2) rund geschliffen wird.

10. Verfahren nach Anspruch 8 oder 9, **dadurch gekennzeichnet,** daß die dünne lichtempfindliche Schicht (3) durch einTauchverfahren oder ein Tauchringrakelverfahren aufgebracht wird.

11. Verfahren nach Anspruch 8 oder 9, **dadurch gekennzeichnet,** daß die dünne lichtempfindliche Schicht (3) durch Aufsprühen gebildet wird.

12. Verfahren nach einem der Ansprüche 8 bis 11, **dadurch gekennzeichnet,** daß während der punktweisen Belichtung der dünnen lichtempfindlichen Schicht (3) ein Überdruck im Innern des Hohlzylinders erzeugt wird.

13. Verfahren nach einem der Ansprüche 1 bis 12, **dadurch gekennzeichnet,** daß beim Entwickeln der Fotoelastomerschicht (2) das Herauslösen von unvernetzten Stellen aus dem Polymerverband durch Bürsten unterstützt wird.

14. Verfahren nach einem der Ansprüche 1 bis 13, **dadurch gekennzeichnet,** daß die großflächige Belichtung der Fotoelastomerschicht (2) so erfolgt, daß diese bis zum Boden vernetzt wird.

15. Verfahren nach einem der Ansprüche 1 bis 14, **dadurch gekennzeichnet,** daß die entwickelte Fotoelastomerschicht (2) durch großflächige Belichtung nachvernetzt wird.

16. Vorrichtung zur Durchführung des Verfahrens nach einem der Ansprüche 1 bis 15, mit einer an sich bekannten Bearbeitungsstation, die wenigstens eine Lagereinrichtung (5, 6) zur stirnseitigen Lagerung eines Zylinders (4) und eine Antriebseinrichtung zur Drehung des Zylinders (4) um seine Zylinderachse (15) aufweist, **dadurch gekennzeichnet,** daß an der Bearbeitungsstation ein Lichtbalken (28) angeordnet ist, der sich bei eingespanntem Zylinder (4) über dessen gesamte Länge in Zylinderlängsrichtung erstreckt und durch einen Spalt (30) hindurch Licht in Richtung zum Zylinder (4) abstrahlt.

17. Vorrichtung nach Anspruch 16, **dadurch gekennzeichnet,** daß der Spalt (30) durch einen in Längsrichtung des Lichtbalkens (28) verlaufenden schmalen Trichter (31) gebildet ist, der auf die Rotationsachse des Zylinders (4) ausgerichtet ist.
